# EUROPÄISCHE PATENTSCHRIFT

(11) **EP 1 917 844 B1**
(45) Veröffentlichungstag und Bekanntmachung des Hinweises auf die Patenterteilung: **20.10.2010**
(21) Anmeldenummer: 06777763.1
(22) Anmeldetag: 13.07.2006
(51) Int. Cl.: H05K 3/34

(54) **VERFAHREN ZUM LÖTEN VON SMD-BAUTEILEN AUF EINER LEITERPLATTE UND REFLOW-LÖTOFEN DAZU**
METHOD FOR SOLDERING SMD COMPONENTS ON A PRINTED CIRCUIT BOARD AND REFLOW SOLDERING FURNACE THEREFOR
PROCEDE POUR SOUDER DES COMPOSANTS SMD SUR UNE CARTE DE CIRCUITS IMPRIMES ET FOUR DE SOUDURE PAR REFUSION A CET EFFET

(30) Priorität: 22.08.2005 DE 102005039829
(43) Veröffentlichungstag der Anmeldung: 07.05.2008
(73) Patentinhaber: Endress+Hauser GmbH+Co. KG, 79689 Maulburg (DE)
(72) Erfinder: BIRGEL, Dietmar, 79650 Schopfheim (DE); HAUPTVOGEL, Karl-Peter, F-68870 Bartenheim (FR)
(74) Vertreter: Andres, Angelika Maria
(86) Internationale Anmeldenummer: PCT/EP2006/064215
(87) Internationale Veröffentlichungsnummer: WO 2007/023030

(56) Entgegenhaltungen:
- EP-A1- 0 237 151
- EP-A2- 0 469 788
- WO-A2-03/079743
- US-A- 5 785 233
- US-A- 6 123 247
- US-A1- 2003 005 581
- US-B1- 6 402 011

## Beschreibung

Die Erfindung betrifft ein Verfahren zum Löten, insbesondere von thermisch kritischen Bauteilen auf einer Leiterplatte mit bleifreier Lotpaste in einem Reflow-Lötofen, eine Leiterplatte für solch ein Verfahren und einen Reflow-Lötofen.

Infolge gesetzlicher Bestimmungen, die den Gehalt von Blei in elektronischen Schaltungen reglementieren, sind Hersteller solcher Schaltungen gezwungen, Herstellungsprozesse im Reflow-Lötofen auf bleifreie Bauteile und bleifreie Lote umzustellen.

Bleifreie Lote haben jedoch eine höhere Schmelztemperatur als bisher verwendete bleihaltigen Lote. Schmelztemperaturen aktueller bleifreier Lote liegen bei etwa 217-230 °C, wo hingegen Schmelztemperaturen bleihaltiger Lote heute etwa bei 178-183 °C liegen. Es ist jedoch zu beachten, daß im Lötprozeß in einem Reflow-Lötofen Löttemperaturspitzen bis zu 260 °C erzeugt werden müssen, um die notwendige Löttemperatur im bleifreien Lot auf der Leiterplatte zu erreichen. Viele elektrische oder elektronische Bauteile, die heute für elektronische Schaltungen auf Leiterplatten gelötet werden, sind jedoch nicht für Schmelztemperaturen bleifreier Lote sondern nur für Temperaturspitzen bis maximal 225°C. Es gibt sogar Hersteller von oberflächenmontierten Bauteilen (SMD-Bauteilen), die angekündigt haben, daß sie nicht bereit sind, zur Zeit erhältliche SMD-Bauteil zukünftig mit Gehäusen herzustellen und zu liefern, die auch für Löttemperaturspitzen im Reflow-Lötofen geeignet sind, wie sie für bleifreie Lösungen erforderlich. WO-A-03/079743 offenbart ein Lötverfahren und einen Reflow-Ofen zum Löten einer Leiterplatte mit einer ersten und einer zweiten Seite und mit wenigstens einem bedrahteten elektrischen Bauteil ("THT-Bauteil") mit wenigstens einem Anschlussdraht oder Anschluss-Pin und einem bzw. einer für konventionelle automatische Löttechnik thermisch kritischen Gehäuse oder Umhüllung, **dadurch gekennzeichnet, dass** die mit dem THT-Bauteil bestückte erste Seite der Leiterplatte beim Löten des auf der zweiten Seite der Leiterplatte im Bereich einer mit einer Lotpaste bedruckten Lötkontaktfläche herausgeführten Anschlussdrahts des THT-Bauteils von einer die Lötung bewirkenden Wärme- oder Energiezufuhr abgeschirmt ist.

Der Erfindung liegt daher die Aufgabe zugrunde, bleifreie Lötungen von thermisch kritischen, oberflächenmontierten Bauteilen im Reflow-Lötofen zusammen mit thermisch unkritischen SMD-Bauteilen zu ermöglichen, auch wenn die Gehäuse der thermisch kritischen Bauteile den üblicherweise für bleifreie Lötungen im Reflow-Lötofen erforderlich Löttemperaturspitzen bei bekannten Lötverfahren nicht standhalten, indem sie Verfahren zum Löten, eine entsprechende Leiterplatte und einen Reflow-Lötofen schafft.

Diese Aufgabe wird nach der Erfindung gelöst durch eine erste Variante eines Verfahrens zum Löten von SMD-Bauteilen auf einer Leiterplatte mit bleifreier Lotpaste in einem Reflow-Lötofen mit folgenden Verfahrensschritten:
- nach Auftragen der Lotpaste auf eine erste Seite der Leiterplatte werden thermisch unkritische SMD-Bauteile und wenigstens ein thermisch kritisches SMD-Bauteil in die Lotpaste eingesetzt;
- die bestückte Leiterplatte wird mit ihrer ersten Seite nach oben in einem Reflow-Lötofen derart plaziert und transportiert, daß eine erste Wärmeenergiequelle, die in einem oberen Bereich einer Lötkammer des Reflow-Lötofen angeordnet ist, eine Wärmeenergie erzeugt, die auf die erste Seite der Leiterplatte einwirkt und die zu einer Temperatur an den dort bestückten Bauteilen führt, die kleiner ist als eine kritische Temperatur des thermisch kritischen SMD-Bauteils;
- wobei eine zweite Wärmeenergiequelle, die in einem unteren Bereich der Lötkammer des Reflow-Lötofen angeordnet ist, eine Wärmeenergie erzeugt, die auf eine zweite untere Seite der Leiterplatte einwirkt und die durch die Leiterplatte hindurch zur ersten Seite der Leiterplatte übertragen wird und in der Lotpaste auf der ersten Seite der Leiterplatte ein Aufschmelzen bewirkt,
- nach der Lötung der SMD-Bauteile auf der ersten Seite der Leiterplatte wird bleifreie Lotpaste auf die zweite Seite der Leiterplatte aufgetragen und thermisch unkritische SMD-Bauteile werden in die Lotpaste auf der zweiten Seite eingesetzt;
- die Leiterplatte wird mit ihrer zweiten, bestückte Seite nach oben im Reflow-Lötofen derart plaziert und transportiert, daß die erste Wärmeenergiequelle eine Wärmeenergie erzeugt, die auf die oben liegende zweite Seite der Leiterplatte einwirkt und zu einer Aufschmelzung der bleifreien Lotpaste führt,
- wobei die Wärmeabgabe der im unteren Bereich der Lötkammer des Reflow-Lötofens angeordnete zweite Wärmeenergiequelle wenigstens soweit gedrosselt wird, daß auf der unten liegende erste Seite der Leiterplatte und an den darauf bereits gelöteten SMD-Bauteilen eine Temperatur erreicht wird, die kleiner ist als eine kritische Temperatur des thermisch kritischen SMD-Bauteils.

Die oben genannte Aufgabe wird auch gelöst durch eine weitere erfindungsgemäße Variante des Verfahrens zum Löten von SMD-Bauteilen auf einer Leiterplatte mit bleifreier Lotpaste in einem Reflow-Lötofen mit folgenden Verfahrensschritten:
• nach Auftragen der Lotpaste auf eine erste Seite der Leiterplatte werden thermisch unkritische SMD-Bauteile und wenigstens ein thermisch kritisches SMD-Bauteil in die Lotpaste eingesetzt;
• die bestückte Leiterplatte wird mit ihrer ersten Seite nach oben in einem Reflow-Lötofen derart plaziert und transportiert, daß eine erste Wärmeenergiequelle, die in einem oberen Bereich einer Lötkammer des Reflow-Lötofen angeordnet ist, eine Wärmeenergie erzeugt, die auf die erste Seite der Leiterplatte einwirkt und die zu einer Temperatur an den dort bestückten Bauteilen führt, die kleiner ist als eine kritische Temperatur des thermisch kritischen SMD-Bauteils;
• wobei eine zweite Wärmeenergiequelle, die in einem unteren Bereich der Lötkammer des Reflow-Lötofen angeordnet ist, eine Wärmeenergie erzeugt, die auf eine zweite untere Seite der Leiterplatte einwirkt und die durch die Leiterplatte hindurch zur ersten Seite der Leiterplatte übertragen wird und in der Lotpaste auf der ersten Seite der Leiterplatte ein Aufschmelzen bewirkt,
• nach der Lötung der SMD-Bauteile auf der ersten Seite der Leiterplatte wird bleifreie Lotpaste auf die zweite Seite der Leiterplatte aufgetragen und thermisch unkritische SMD-Bauteile werden in die Lotpaste auf der zweiten Seite eingesetzt;
• die Leiterplatte wird mit ihrer zweiten, bestückte Seite nach oben im Reflow-Lötofen derart plaziert und transportiert, daß die erste Wärmeenergiequelle eine Wärmeenergie erzeugt, die auf die oben liegende zweite Seite der Leiterplatte einwirkt und zu einer Aufschmelzung der bleifreien Lotpaste führt,
• wobei im unteren Bereich der Lötkammer des Reflow-Lötofens eine Kühlvorrichtung angeordnet ist, die zum Kühlen der unten liegenden ersten Seite der Leiterplatte und der darauf bereits gelöteten SMD-Bauteile dient, so daß an den darauf bereits gelöteten SMD-Bauteilen eine Temperatur erreicht wird, die kleiner ist als eine kritische Temperatur des thermisch kritischen SMD-Bauteils.

Bei einer besonderen Ausführung eines Verfahrens nach der Erfindung ist vorgesehen, daß für den Fall einer Bestückung und Lötung der ersten Seite der Leiterplatte mit wenigstens einem bedrahteten Bauteil,
- die Leiterplatte nach dem Auftragen der Lotpaste auf die zweite Seite gewendet wird;
- Anschlußdrähte bzw. -Pins des bedrahteten Bauteils von der ersten Seite der Leiterplatte her in dafür vorgesehene Anschlußbohrungen gesteckt werden;
- die Leiterplatte dann gewendet wird; und
- die SMD-Bauteile auf der zweiten Seite in die Lotpaste eingesetzt werden

Bei einer anderen Ausführung des erfindungsgemäßen Verfahrens umfaßt die zweite Wärmeenergiequelle im Reflowofen wenigstens einen Infrarot-Strahler.

Bei einer noch anderen Ausführung des erfindungsgemäßen Verfahrens wird durch teilweise Abdeckung der zweiten Seite der Leiterplatte eine punktuelle Einwirkung der Wärmeenergie der zweiten Wärmeenergiequelle auf die zweite Seite der Leiterplatte erreicht.

Bei wieder einer anderen Ausführung des Verfahrens nach der Erfindung wird die teilweise Abdeckung der zweiten Seite der Leiterplatte mit einer Maske erreicht.

Weiterhin wird die oben genannte Aufgabe gelöst durch eine andere Variante des Reflow-Lötofens nach der Erfindung zum Löten von SMD-Bauteilen und wenigstens einem auf einer ersten Seite einer Leiterplatte in bleifreie Lötpaste eingesetztem thermisch kritischen SMD-Bauteil, welcher Reflow-Lötofen eine in einem oberen Bereich einer Lötkammer des Reflow-Lötofen angeordnete erste Wärmeenergiequelle aufweist und eine in einem unteren Bereich der Lötkammer des Reflow-Lötofen angeordnete zweite Wärmeenergiequelle, wobei die von den Wärmeenergiequellen abgegebenen Wärmeenergien unabhängig voneinander so einstellbar sind, daß
- zum Löten von des thermisch kritischen SMD-Bauteils auf der ersten Seite der Leiterplatte die von der zweiten Wärmeenergiequelle erzeugte Wärmeenergie auf eine zweite Seite der Leiterplatte so einwirkt, daß die Wärmeenergie durch die Leiterplatte hindurch übertragen und die Lotpaste auf der ersten Seite der Leiterplatte schmilzt; und
- wobei nach einem Wenden der Leiterplatte zum Löten von SMD-Bauteilen, die auf einer zweiten Seite der Leiterplatte in bleifreie Lotpaste eingesetzt sind, eine im unteren Bereich der Lötkammer des Reflow-Lötofens angeordnete Kühlvorrichtung die ersten Seite der Leiterplatte und der darauf bereits gelöteten SMD-Bauteile so kühlt, daß an den darauf bereits gelöteten SMD-Bauteilen eine Temperatur erreicht wird, die kleiner ist als eine kritische Temperatur des thermisch kritischen SMD-Bauteils; und wobei die zweite Wärmeenergiequelle wenigstens einen Infrarot-Strahler umfaßt; und die Kühlvorrichtung und der Infrarotstrahler eine gemeinsame Baugruppe bilden.

Die Erfindung wird nachfolgend und unter Hinweis auf die in der beigefügten Zeichnung dargestellten Ausführungsbeispiele erläutert und beschrieben.

Dabei zeigen:

Fig. 1 eine schematische Darstellung einer Leiterplatte, vorbereitet zum Löten in einem Reflow-Lötofen;

Fig. 2 eine schematische Darstellung einer bevorzugten Ausführungsform eines Reflow-Lötofens nach der Erfindung;

Fig. 3 eine schematische Darstellung einer Baugruppe aus Kühlvorrichtung und Infrarotstrahler für einen Reflow-Lötofen nach Fig. 2;

Fig. 4 eine schematische Darstellung eines Ausschnitts einer bevorzugten Ausführungsform der Leiterplatte nach Fig. 1 in vergrößertem Maßstab;

Fig. 5 eine schematische Darstellung eines Verfahrens nach der Erfindung; und

Fig. 6 ein typisches Temperatur-Zeit-Diagramm in der Lötkammer des Reflow-Lötofens nach Fig. 2 bei Durchführung des erfindungsgemäßen Verfahrens.

Zur Vereinfachung sind in der Zeichnung gleiche Elemente, Module und Baugruppen mit gleichen Bezugszeichen versehen, soweit dies sinnvoll und zweckdienlich erscheint.

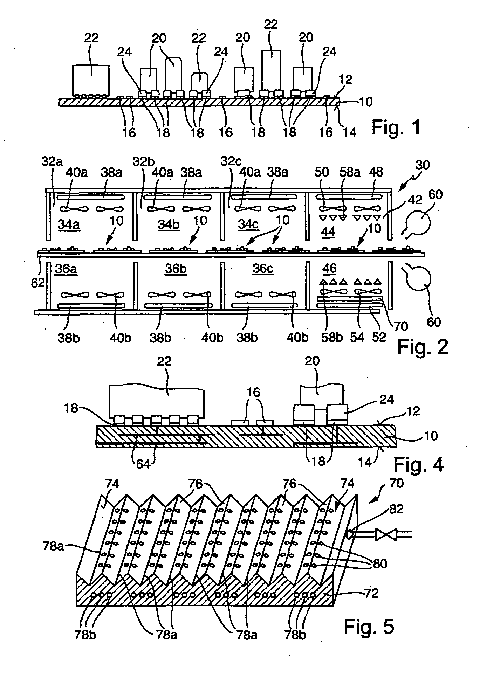

In Fig. 1 ist eine Leiterplatte 10 mit einer ersten Seite 12 und einer zweiten Seite 14 schematisch dargestellt. Auf der ersten Seite 12 der Leiterplatte 10 sind Leiterbahnen 16 und Kontaktflächen 18, sonst auch Lötpads genannt, zur Verbindung mit elektrischen bzw. elektronischen Bauteilen 22. Aus Gründen der Vereinfachung ist die zweite Seite 14 der Leiterplatte 10 ohne Leiterbahnen, Kontaktflächen und Bauteile dargestellt.

Bei den Bauteilen werden thermisch unkritische Bauteile 20 und thermisch kritische Bauteile 22 unterschieden. Wie bereits oben beschrieben sind mit dem Begriff "thermisch kritische Bauteile" solche elektrischen bzw. elektronischen Bauteile gemeint, die die Schmelztemperaturen von bleifreien Loten und die dafür in einem üblicherweise an den Bauteilen herrschenden Temperaturspitzen nicht schadlos überstehen. Unter "Temperaturspitzen" sind dabei solche zu verstehen, die von einer Wärmeenergiequelle oberhalb der Bauteile und einer direkten Wärmeenergie-Übertragung an den Bauteilen selbst erzeugt werden.

Wie Fig. 1 verarischaulicht, sind die Bauteile 20, 22 bereits in bleifreie Lotpaste 24, die auf die Kontaktflächen 18 aufgebracht wurde, eingesetzt. Die in Fig. 1 dargestellte und auf ihrer ersten Seite 12 bestückte Leiterplatte 10 ist bereit, um in einem Reflow-Lötofen 30 (siehe dazu Fig. 2) gelötet zu werden. Obwohl das eigentliche erfindungsgemäße Verfahren zum Löten von SMD-Bauteilen 20, 22 mit bleifreier Lotpaste 24 das Löten der ersten Seite 12 als auch das Löten der zweiten Seite 14 der Leiterplatte betrifft, ist in Fig. 1 zur Veranschaulichung nur die bestückte und zum Löten bereite ersten Seite 12 dargestellt. Bei den hier beschriebenen Ausführungen des erfindungsgemäßen Verfahrens zum Löten von SMD-Bauteilen 20, 22 mit bleifreier Lotpaste 24 wird zunächst davon ausgegangen, daß thermisch kritische Bauteile 22 nur auf der ersten Seite 12 der Leiterplatte 10 plaziert werden. Auf eine Darstellung der bestückten zweiten Seite 14 der Leiterplatte 10 wurde daher in Fig. 1 zur Vereinfachung und Übersichtlichkeit verzichtet.

In Fig. 2 ist ein Ausführungsbeispiel eines Reflow-Lötofens 30 nach der Erfindung schematisch dargestellt. Wie bekannte Reflow-Lötöfen auch weist der Reflow-Lötofen 30 mehrere Vorwärmkammern auf, von denen zur Vereinfachung in Fig. 2 drei Vorwärmkammern 32a, 32b, 32c dargestellt sind. Jede dieser Vorwärmkammern 32a, 32b, 32c umfaßt einen oberen Bereich 34a, 34b, 34c sowie einen unteren Bereich 36a, 36b, 36c in denen jeweils wenigstens eine Wärmeenergiequelle 38a im oberen Bereich 34a, 34b, 34c und ein Ventilator 40a sowie wenigstens eine Wärmeenergiequelle 38b im unteren Bereich 36a, 36b, 36c und ein Ventilator 40b angeordnet sind, die zur Vorwärmung der den Reflow-Lötofen 30 durchlaufenden Leiterplatten 10 (siehe dazu auch Fig. 1) dienen.

Nach der letzten Vorwärmkammer 32c wird jede Leiterplatte 10 in eine Lötkammer 42 transportiert, wo die bleifreie Lotpaste 24 geschmolzen und die Bauteile 20, 22 auf der ersten Seite der Leiterplatten 10 (siehe dazu auch Fig. 1) auf die betreffenden Kontaktflächen 18 gelötet werden. Wie Fig. 2 zeigt, werden üblicherweise mehrere Leiterplatten 10 durch den Reflow-Lötofen 30 transportiert, die jeweils auch in einem Nutzen zusammengefaßt werden können. Die Leiterplatten 10 werden von bekannten einem Kettenförderer durch den Reflow-Lötofen 30 transportiert, wobei in Fig. 2 zur Vereinfachung nur ein Kettenförderband 62 schematisch dargestellt ist.

Die Lötkammer 42 umfaßt einen oberen Bereich 44 und einen unteren Bereich 46, die - wie bei anderen bekannten Reflow-Lötofen 30 auch - jeweils wenigstens eine erste Wärmeenergiequelle 48 im oberen Bereich 44 und wenigstens eine zweite Wärmeenergiequelle 52 im unteren Bereich 46 umfassen. Das Besondere bei diesem erfindungsgemäßen Reflow-Lötofen 30 ist jedoch, daß eine direkt auf die erste Seite 12 der Leiterplatte 10 (siehe dazu Fig. 1) einwirkende Wärmeenergieabgabe der im oberen Bereich 44 der Lötkammer 42 angeordneten ersten Wärmeenergiequelle 48 unabhängig einstellbar ist gegenüber einer Wärmeenergieabgabe der zweiten, auf die zweite Seite 14 der Leiterplatte 10 einwirkenden Wärmequelle 52 im unteren Bereich 36b der Lötkammer 42 des Reflow-Lötofens 30. Zur Verteilung der von der ersten Wärmeenergiequelle 48 abgegebenen Wärmeenergie dient ein Ventilator 50 im oberen Bereich 44 der Lötkammer 42, zur Verteilung der von der zweiten Wärmeenergiequelle 52 abgegebenen Wärmeenergie dient ein Ventilator 54 im unteren Bereich 36b der Lötkammer 42 des Reflow-Lötofens 30.

Wie weiter unten noch erläutert wird, wird zum erfindungsgemäßen Löten der bleifreien Lotpaste 24 auf der ersten Seite 12 der Leiterplatte 10 (siehe dazu auch die Fig. 1) die Wärmeenergieabgabe der zweiten Wärmequelle 52 derart eingestellt, daß die von ihr abgegebene Wärmeenergie durch die Leiterplatte 10 hindurch übertragen wird und die Lotpaste 24 auf der ersten Seite 12 der Leiterplatte 10 aufschmilzt. Demgegenüber wird die Wärmeenergieabgabe der im oberen Bereich 44 der Lötkammer 42 angeordneten ersten Wärmeenergiequelle 48 derart eingestellt, daß die an den thermisch kritischen SMD-Bauteilen 22 auf der ersten Seite 12 der Leiterplatte 10 erzeugte Temperatur kleiner ist als die kritische Temperatur der thermisch kritischen SMD-Bauteile 22. Vorzugsweise wird die Wärmeenergieabgabe der zweiten Wärmequelle 52 so eingestellt ist, daß die in der Lotpaste 24 auf der ersten Seite 12 der Leiterplatte 10 erzielbare Temperatur um mindestens 10 Kelvin größer ist als eine durch die Energieabgabe der erste Wärmequelle 48 am thermisch kritischen SMD-Bauteil 22 auf der erste Seite 12 der Leiterplatte 10 erzeugte Temperatur (siehe dazu auch die Fig. 1). Um diese Maßnahmen zu erreichen, ist bei dem erfindungsgemäßen Reflow-Lötofen 30 vorgesehen, daß die zweite Wärmequelle 52 im unteren Bereich 46 der Lötkammer 42 des Reflow-Lötofens 30 wenigstens einen, vorzugsweise mehrere, Infrarot-Strahler 58b umfaßt, die die zweite Seite 14 der Leiterplatte 10 direkt abstrahlen.

Weiter unten wird eine besondere Ausführungsform des Verfahrens zum Löten von SMD-Bauteilen mit bleifreier Lotpaste beschrieben, bei dem auch eine Lötung der zweiten Seite 14 der Leiterplatte 10 durchgeführt wird. Die bleifreie Lotpaste 24 (siehe dazu Fig. 1), die in diesem Fall auf die zweite Seite 14 der Leiterplatte 10 aufgebracht wurde, wird dazu direkt durch die Wärmeenergieabgabe der ersten Wärmeenergiequelle 48 im oberen Bereich 44 der Lötkammer 42 des Reflow-Lötofens 30 aufgeschmolzen. Vorzugsweise wird die Wärmeenergieabgabe dabei unterstützt durch wenigstens einen, vorzugsweise jedoch mehrere, Infrarotstrahler 58a, der bzw. die, wie in Fig. 2 dargestellt, im oberen Bereich 44 der Lötkammer 42 des Reflow-Lötofens 30 angeordnet ist bzw. sind.

Für den Fall, daß, wie später noch erklärt, die Temperatur an den Bauteilen 20, 22 auf der ersten Seite 12 der Leiterplatte 10, die beim Löten der Bauteile der zweiten Seite 14 der Leiterplatte 10 nach unten im Reflow-Lötofen weist, eine viel geringere sein soll als auf der zu lötenden zweiten Seite 14, ist es sinnvoll im unteren Bereich 46 der Lötkammer 42 zu kühlen. Besonders vorteilhaft ist dabei eine der Kühlung dienende Baugruppe 70, wie sie in Fig. 2 veranschaulicht ist. Fig. 5 und der dazu gehörende erläuternde Beschreibungstext stellen eine besondere erfindungsgemäße Baugruppe 70 vor, bei der die oben erwähnte Kühlung und die im unteren Bereich 46 der Lötkammer 42 in Fig. 2 dargestellten Infrarotstrahler 58b im unteren Bereich 46 der Lötkammer 42 in einer Einheit zusammengefaßt sind.

Direkt hinter dem Reflow-Lötofen 30 ist eine äußere Kühlvorrichtung außerhalb des Reflow-Lötofens 30 zur Abkühlung der die Lötkammer 30 verlassenden gelöteten Leiterplatten 10 vorgesehen. Die Kühlvorrichtung besteht aus an sich bekannten Kühlgebläsen 60, die, wie in Fig. 2 dargestellt, vorzugsweise so angeordnet sind, daß sie die erste Seite 12 und die zweite Seite 14 der Leiterplatten 10 bestreichen können.

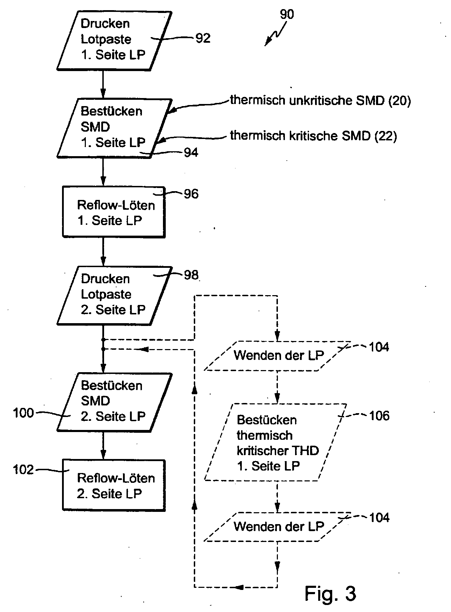

Fig. 3 veranschaulicht das erfindungsgemäße eigentliche Verfahren nach der Erfindung zum Verfahren zum Löten von Leiterplatten 10 mit bleifreier Lotpaste 24 im Reflow-Lötofen 30 (siehe dazu Fig. 2) in einem Fließdiagramm.

Nach einem Auftragen, vorzugsweise Drucken 92, der Lotpaste 24 auf die erste Seite 12 der Leiterplatte 10 wird eine Bestückung 94 der ersten Seite 12 mit thermisch unkritischen SMD-Bauteilen 20 und wenigstens einem thermisch kritisches SMD-Bauteil 22 vorgenommen, vorzugsweise wie in Fig. 1 veranschaulicht: mit mehreren thermisch kritischen SMD-Bauteilen 22, indem diese SMD-Bauteile 20, 22 in die Lotpaste 24 eingesetzt werden, beispielsweise mit einem Bestückungsautomaten. Die derart auf ihrer ersten Seite 12 bestückte Leiterplatte 10 wird zu einer Lötung 96 zusammen mit anderen Leiterplatten 10, die beispielsweise in einem oder in mehreren Nutzen gehalten werden, mit ihrer ersten Seite 12 nach oben im erfindungsgemäßen Reflow-Lötofen 30 (siehe dazu auch Fig. 2) derart plaziert und transportiert, daß eine erste Wärmeenergiequelle 48 im oberen Bereich 44 auf die erste Seite 12 der Leiterplatte 10 einwirkt, die zu einer Temperatur an den dort bestückten Bauteilen 20, 22 führt, die kleiner ist als eine kritische Temperatur des thermisch kritischen SMD-Bauteils 22. Die zweite Wärmeenergiequelle 52 im unteren Bereich 46 der Lötkammer 42 des Reflow-Lötofen 30, vorzugsweise mit dem oder mehreren Infrarot-Strahlern 58b strahlt und wirkt direkt auf die zweite unten liegende Seite 14 der Leiterplatte 10 ein. Die von der zweiten Wärmeenergiequelle 52 und den Infrarot-Strahlern 58b erzeugte Wärmeenergie wird durch die Leiterplatte 10 hindurch zur ersten Seite 12 der Leiterplatte 10 übertragen, so daß die Lotpaste 24 auf der ersten Seite 12 der Leiterplatte 10 aufgeschmolzen wird und die Bauteile 20, 22 auf den Kontaktflächen 18 der ersten Seite 12 der Leiterplatte 10 verlötet werden. Zur wirksamen Lötung 96 mit der bleifreien Lotpaste 24 ist es empfehlenswert, wenn die durch die indirekte Wärmeübertragung in der Lotpaste 24 erzeugte Temperatur um mindestens 10 Kelvin größer ist als die durch die erste Wärmeenergiequelle 48 an den Bauteilen20, 22 auf der erste Seite 12 der Leiterplatte 10 erzeugte Temperatur.

Wie beschrieben, wird vorzugsweise die indirekte Erwärmung der Lotpaste 24 auf ersten Seite 12 der Leiterplatte 10 durch mehrere Infrarot-Strahler 58b der zweiten Wärmeenergiequelle 52 im unteren Bereich 46 der Lötkammer 42 herbeigeführt. Die Bestrahlung der unten liegenden zweiten Seite 14 der Leiterplatte 10 kann dabei punktuell eingestellt oder auf bevorzugte Bereiche der zweiten Seite 14 der Leiterplatte gerichtet werden, indem die zweite Seite 14 teilweise abgedeckt wird, beispielsweise durch eine entsprechende Maske.

Nach dem Löten 96 der SMD-Bauteile 20, 22 auf der ersten Seite 12 der Leiterplatte 10 findet eine Auftragung, vorzugsweise ein Drucken 98, von bleifreier Lotpaste 24 auf die zweite Seite 14 der Leiterplatte 10 statt. Dann erfolgt eine Bestückung 100 der zweiten Seite 14, indem thermisch unkritische SMD-Bauteile 20 in die Lotpaste 24 auf der zweiten Seite 14 eingesetzt werden, beispielsweise durch einen Bestückungsautomaten.

Die Leiterplatte 10 bzw. die Leiterplatten 10 werden zum Löten 102 im Reflow-Lötofen 30 (siehe dazu auch Fig. 2) mit ihrer zweiten, nun bestückten Seite 14 nach oben im Reflow-Lötofen 30 derart plaziert und transportiert, daß die erste Wärmeenergiequelle 48 im oberen Bereich 44 der Lötkammer 42 eine Wärmeenergie erzeugt, die auf die oben liegende zweite Seite 14 der Leiterplatten 10 einwirkt und zu einer Aufschmelzung der bleifreien Lotpaste 24 führt, so daß auf diese Weise die Bauteile auf der zweiten Seite 14 der Leiterplatte 10 verlötet werden. Für besondere Fälle hat es sich auch als sinnvoll erwiesen, die im erfindungsgemäßen Reflow-Lötofen 30 im oberen Bereich 44 der Lötkammer 42 vorzugsweise angeordneten Infrarotstrahler 58a zur Verstärkung der auf die zweite Seite 14 der Leiterplatte 10 bei Löten 102 einwirkenden Wärmenergie heranzuziehen.

Wie bereits oben beschrieben, erlaubt es der erfindungsgemäße Reflow-Lötofen 30, die von den Wärmeenergiequellen 48, 52 der Lötkammer 42 abgegebenen Wärmeenergien unabhängig voneinander einzustellen. So ist es möglich, beim Löten 102 der zweiten Seite 14 der Leiterplatte 10 eine Temperatur an den bereits gelöteten Bauteile und insbesondere den thermisch kritischen Bauteilen 22 auf der nach unten weisenden ersten Seite 12 der Leiterplatte 10 (siehe dazu auch Fig. 2) zu erzielen, die deutlich unter der kritischen Temperatur der thermisch kritischen Bauteilen 22 bleibt.

Zum Löten 102 der zweiten Seite 14 der Leiterplatte 10 wird daher die Wärmeabgabe der im unteren Bereich 46 der Lötkammer 42 des Reflow-Lötofens 30 angeordnete zweite Wärmeenergiequelle 52 gegenüber der Wärmeabgabe der im oberen Bereich 48 der Lötkammer 42 des Reflow-Lötofens 30 angeordnete ersten Wärmeenergiequelle 52 unter die kritische Temperatur des bzw. der thermisch kritischen SMD-Bauteile 22 auf der ersten Seite 12 der Leiterplatte 10 gedrosselt. So wird auch ein erneutes Aufschmelzen des bereits gelöteten Lotes auf der ersten Seite 12 der Leiterplatte 10 verhindert.

Für den Fall, daß die erste Seite 12 der Leiterplatte 10 neben den bereits erwähnten SMD-Bauteilen 20, 22 auch mit bedrahteten, sogenannten THT-Bauteilen bestückt werden soll, werden diese zusammen mit den SMD-Bauteilen auf der zweiten Seite 14 der Leiterplatte 10 gelötet. Da Anschlußpins bzw. Anschlußdrähte dieser THT-Bauteile durch entsprechende Bohrungen der Leiterplatte 10 hindurchgesteckt werden und auf bzw. in entsprechenden Kontaktflächen der zweiten Seite 14 der Leiterplatte 10 münden, wird vorzugsweise beim Auftragen 98 der Lotpaste für die SMD-Bauteile auf die zweite Seite 14 der Leiterplatte 10 auch Lotpaste auf die besagten Kontaktflächen für die Anschlußpins bzw. Anschlußdrähte der THT-Bauteile gebracht.

Um die üblicherweise mehreren THT-Bauteile auf die erste Seite 12 der Leiterplatte 10 bestücken zu können, wird, wie in Fig. 3 dargestellt, nach dem Aufbringen, vorzugsweise Drucken 98, der Lotpaste auf die zweite Seite 14 der Leiterplatte 10 die Leiterplatte 10 gewendet, was in Fig. 3 durch "104" veranschaulicht ist. Dann erfolgt die Bestückung 106 des oder der THT-Bauteile, beispielsweise thermisch kritischer THT-Bauteile, für die sich das erfindungsgemäße Verfahren besonders eignet, auf der ersten Seite 12 der Leiterplatte 10, wobei deren Anschlußpins bzw. Anschlußdrähte von der ersten Seite 12 der Leiterplatte 10 her durch die vorgesehenen Bohrungen durch die Leiterplatte 10 gesteckt werden. Anschließend wird die Leiterplatte 10 erneut gewendet (siehe "104" in Fig. 3) und verfahrensgemäß die oben bereits beschriebene die Bestückung 100 der SMD-Bauteile der zweiten Seite 14 der Leiterplatte 10 durchgeführt. Im Rahmen des nachfolgenden, oben ebenfalls bereits beschriebenen Lötens 102 vorzugsweise im erfindungsgemäßen Reflow-Lötofen 30 (siehe dazu Fig. 2) werden die SMD-Bauteile auf der zweiten Seite 14 der Leiterplatte 10 und Lötstellen der besagten THT-Bauteile auf der ersten Seite 12 der Leiterplatte 10 gelötet.

Bei thermisch besonders kritischen THT-Bauteile auf der ersten Seite 12 der Leiterplatte 10 hat sich gezeigt, daß eine zusätzliche Kühlung im unteren Bereich 52 der Lötkammer während des Lötens 102 (siehe dazu Fig. 3 und 5) der zweiten Seite 14 der Leiterplatte 10 sehr vorteilhaft ist. Dadurch kann an den thermisch besonders kritischen THT-Bauteilen auf der im Reflow-Lötofen 30 (siehe dazu Fig. 2) unten liegenden der ersten Seite 12 der Leiterplatte 10 eine Temperatur erzielt werden, die auch für thermisch besonders kritische THT-Bauteile unschädlich ist. Wie bereits oben beschrieben, ist erfindungsgemäß dafür im unteren Bereich 46 der Lötkammer 42 des Reflow-Lötofens 30 (siehe dazu Fig. 2) eine Kühlvorrichtung vorgesehen, die vorzugsweise mit als Baugruppe 70 ausgeführt ist, bei der die Kühlvorrichtung und die in Fig. 2 dargestellten Infrarotstrahler 58b im unteren Bereich 46 der Lötkammer 42 in einer Einheit zusammengefaßt sind. Diese Baugruppe 70 wird weiter unten im Zusammenhang mit Fig. 5 näher erläutert und beschrieben.

Eine andere Möglichkeit, gezielt die indirekte Erwärmung der bleifreien Lotpaste 24 auf der ersten Seite 12 der Leiterplatte 10 zu steuern, d.h. die Wärmeübertragung durch die Leiterplatte 10 hindurch punktuell zu verbessern oder zu verhindern, ist in Fig. 4 veranschaulicht. Bei der dort ausschnittweise dargestellten Leiterplatte 10 nach der Erfindung (siehe dazu Fig. 1) ist wenigstens eine leitende Innenlage 64 vorgesehen, die üblicherweise aus Kupfer besteht und deren Layout derart gestaltet ist, daß die Wärmeleitung zur Lotpaste 24 auf der ersten Seite 12 der Leiterplatte 10 an vorbestimmbaren Stellen und insbesondere im Bereich der Kontaktflächen 18 der thermisch kritischen Bauteile 22 auf der ersten Seite 12 der Leiterplatte 10 unterstützt wird. Eine großflächige Innenlage 64 leitet die Wärmeenergie besser durch die Leiterplatte 10 hindurch. Mehrere großflächige Innenlagen 64, wie in Fig. 3 dargestellt, die zudem noch miteinander elektrisch leitend verbunden sind, sorgen für eine optimale und kontrollierte Wärmeleitung zu gewünschten, vorbestimmten Kontaktflächen 18.

Fig. 5 ist eine schematische perspektivische Darstellung der oben angesprochenen Baugruppe 70, in der die Kühlvorrichtung und die in Fig. 2 dargestellten Infrarotstrahler 58b im unteren Bereich 46 der Lötkammer 42 in einer Einheit zusammengefaßt sind. Wie Fig. 5 zeigt umfaßt diese erfindungsgemäße Baugruppe 70 eine Grundplatte 72, beispielsweise aus keramischen Material, und eine beim Einbau in den Reflow-Lötofen 30 (siehe dazu Fig. 2) nach oben, zu den durchlaufenden Leiterplatten 10 gerichtete Abstrahl-Oberfläche 74. Diese Abstrahl-Oberfläche 74 weist, wie in Fig. 5 dargestellt, Rippen 76 auf, die beispielsweise aus zueinander parallelen Erhöhungen und Vertiefungen gebildet werden. In den Vertiefungen sind, wie in Fig. 5 veranschaulicht, untereinander verbundene Infrarot-Heizelemente, vorzugsweise drahtförmige IR-Heizelemente 78 angeordnet. Diese IR-Heizelemente 78 werden vorzugsweise von einer hier aus Gründen der Vereinfachung und Übersichtlichkeit nicht dargestellten elektrischen und schaltbaren Energiequelle versorgt. In der Grundplatte 72 der Baugruppe 70 sind untereinander verbundene Bohrungen 80 vorgesehen, die wiederum mit einem Anschluß 82 für ein Kühlmittel verbunden, so daß Kühlmittel durch die Bohrungen 80 in der Grundplatte 72 der Baugruppe 70 zirkulieren kann und diese kühlt. Der Anschluß 82 kann beispielsweise mit einem üblichen Kompressor verbunden sein. Falls der untere Bereich 46 der Lötkammer 42 gekühlt werden soll, wird mit Ventilatoren 54 im unteren Bereich 46 der Lötkammer 42 des erfindungsgemäßen Reflow-Lötofens 30 (siehe dazu Fig. 2) ein Gas oder Luft in der Lötkammer 42 über die vom Kühlmittel gekühlte Abstrahl-Oberfläche 74 der Baugruppe 70 geführt und mit dem gekühlten Luft- bzw. Gasstrom wird die zweite Seite 14 der Leiterplatte 10 angeblasen. In der Praxis hat sich gezeigt, daß durch Kühlen im unteren Bereich der Lötkammer 42 des Reflow-Lötofens30 beim Löten einer oberen Seite der Leiterplatte 10 eine Temperaturdifferenz zwischen einer Temperatur auf bzw. an den Bauteilen auf der Oberseite der Leiterplatte 10 und einer Temperatur auf der Unterseite der Leiterplatte von etwa 100°C erreicht werden kann.

Neben der in Fig..5 dargestellten Abstrahl-Oberfläche 74 für die Baugruppe 70 können auch anders gestaltete Oberflächen verwendet werden, beispielsweise in Wellen- statt in Rippenform, wobei jedoch die geformte Oberfläche gegenüber einer planen, glatten Oberfläche deutlich vergrößert sein sollte , um die Wärmeabstrahlung durch die IR-Heizelemente 78 und - im anderen Fall einer Kühlung - die gekühlte Oberfläche zu optimieren. Weiterhin ist es möglich, die Baugruppe 70 statt aus dem oben beschriebenen keramischen Material aus Metall herzustellen, allerdings sollten dann die IR-Heizelemente 78 gegenüber einer metallischen Abstrahl-Oberfläche 74 isoliert sein.

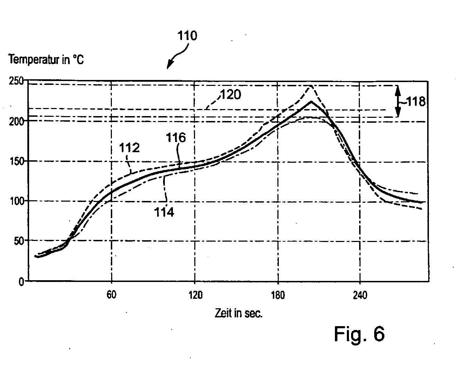

Bereits oben wurde beschrieben, wie wichtig es ist und auf welche Weise die Erfindung dazu dient, thermisch kritische Bauteile gegenüber der beim Löten mit bleifreien Lot erforderlichen Temperatur in der Lötkammer 42 des Reflow-Lötofens 30 zu schützen. Das Ziel ist daher, eine möglichst große Temperaturdifferenz zwischen der Temperatur auf den Kontaktflächen 18 (siehe dazu auch Fig. 1 und 4), also im Lot, und an bzw. auf den thermisch kritischen Bauteilen 22 zu erreichen. Zur Veranschaulichung der mit dem erfindungsgemäßen Verfahren erreichbaren Temperaturdifferenz ist in Fig. 6 ein Beispiel eines typischen Temperatur-Zeit-Diagramms 110 in der Lötkammer 42 des Reflow-Lötofens 30 dargestellt, wie es bei Durchführung des erfindungsgemäßen Verfahrens nach Fig. 2 erreicht wird, und zwar insbesondere beim Löten 96 der Bauteile 20, 22 auf der ersten Seite 12 der Leiterplatte 10 (siehe auch Fig. 3 und dazugehörende Beschreibung). Im Temperatur-Zeit-Diagramm 110 sind drei Kurven dargestellt: eine Kurve 112 des Temperaturverlaufs auf der unteren, der zweiten Seite 14 der Leiterplatte 10, eine Kurve 114 des Temperaturverlaufs auf bzw. an den Bauteilen 20, 22 auf der oberen, der ersten Seite 12 der Leiterplatte 10 und eine Kurve 116 des Temperaturverlaufs auf den Kontaktflächen 18, also in der zu schmelzenden Lotpaste.

Durch die im Reflow-Lötofen 30 auf die untere, die zweite Seite 14 der Leiterplatte 10 einwirkende Wärmeenergie wird auf der unteren, der zweiten Seite 14 der Leiterplatte 10 eine Temperatur von bis zu 245 °C eingestellt, wie aus dem Maximum der Kurve 112 ablesbar ist. Durch die erfindungsgemäß genutzte Wärmeübertragung der Leiterplatte 10 auf die obere, die erste Seite 12 der Leiterplatte 10 wird auf den Kontaktflächen 18, also in der zu schmelzenden Lotpaste eine Temperatur bis zu 225 °C erreicht, wie das Maximum der Kurve 116 zeigt. Die erreichbare maximale Temperatur in der Lotpaste liegt damit deutlich über der zum Löten von bleifreier Lotpaste erforderlichen Temperatur von 217 °C, die im Temperatur-Zeit-Diagramm 110 durch eine gestrichelten Linie 120 veranschaulicht wird. Die an bzw. auf den Bauteilen 20, 22 auf der ersten Seite 12 der Leiterplatte 10 auftretenden Temperaturen sind nicht größer als etwa 205 °C. Eine damit erreichbare Temperaturdifferenz in Bezug auf die Temperatur auf der unteren, der zweiten Seite 14 der Leiterplatte 10 beträgt damit etwa 40 °C und ist in Fig. 6 durch "118" verdeutlicht. Die an bzw. auf den Bauteilen 20, 22 auf der ersten Seite 12 der Leiterplatte 10 auftretenden Temperatur liegt somit unter der für die kritischen Temperatur der thermisch kritischen Bauteile 22 auf der ersten Seite 12 der Leiterplatte 10.

**Bezugszeichen:**

**Tabelle 1**

| | | | | |
|---|---|---|---|---|
| 10 | Leiterplatte | | 54 | Ventilator zu (52) |
| 12 | erste Seite von (10) | | 58a | IR-Strahler in (44) |
| 14 | zweite Seite von (10) | | 58b | IR-Strahler in (46) |
| 16 | Leiterbahn auf (12) | | 60 | Kühlung, Kühlgebläse |
| 18 | Kontaktfläche auf (12) | | 62 | Kettenförderband |
| 20 | thermisch unkritisches Bauteil | | 64 | Innenlage der Leiterplatte |
| 22 | thermisch kritisches Bauteil | | 70 | Baugruppe |
| 24 | bleifreie Lotpaste | | 72 | Grundplatte |
| 30 | Reflow-Lötofen | | 74 | Abstrahl-Oberfläche, gerippt |
| 32a | Vorwärmkammer | | 76 | Rippen |
| 32b | Vorwärmkammer | | 78 | IR-Draht / Heizelement |
| 32c | Vorwärmkammer | | 80 | Bohrungen in (72) |
| 34a | oberer Bereich von (32a) | | 82 | Anschluß für ein Kühlmittel |
| 34b | oberer Bereich von (32b) | | 90 | Verfahren |
| 34c | oberer Bereich von (32c) | | 92 | Drucken Lotpaste 1. Seite LP |
| 36a | unterer Bereich von (32a) | | 94 | Bestücken SMD 1. Seite LP |
| 36b | unterer Bereich von (32b) | | 96 | Löten 1. Seite LP |
| 36c | unterer Bereich von (32c) | | 98 | Drucken Lotpaste 2. Seite LP |
| 38a | Wärmeenergiequelle in 34a, 34b, 34c | | 100 | Bestücken SMD 2. Seite LP |
| 38b | Wärmeenergiequelle in 36a, 36b, 36c | | 102 | Löten 2. Seite LP |
| 40a | Ventilator zu (38a) | | 104 | Wenden LP |
| 40b | Ventilator zu (38b) | | 106 | Bestücken THT |
| 42 | Lötkammer | | 110 | Temperaturprofil-Kurve |
| 44 | oberer Bereich von (42) | | 112 | Temperatur auf (14) |
| 46 | unterer Bereich von (42) | | 114 | Temperatur auf (20, 22) |
| 48 | erste Wärmeenergiequelle im oberen Bereich der Lötkammer | | 116 | Temperatur auf (12, 18) |
| 50 | Ventilator zu (48) | | 118 | Temperaturdifferenz zwischen (114) und (112) |
| 52 | zweite Wärmeenergiequelle im unteren Bereich der Lötkammer | | 120 | Schmelztemperatur bleifreies Lot (24) |

## Patentansprüche

1. Verfahren zum Löten von SMD-Bauteilen auf einer Leiterplatte mit bleifreier Lotpaste in einem Reflow-Lötofen, **gekennzeichnet durch** folgende Verfahrensschritte:
• nach Auftragen der Lotpaste (92) auf eine erste Seite der Leiterplatte werden thermisch unkritische SMD-Bauteile und wenigstens ein thermisch kritisches SMD-Bauteil in die Lotpaste eingesetzt (94),
• die bestückte Leiterplatte wird mit ihrer ersten Seite nach oben in einem Reflow-Lötofen derart plaziert und transportiert, daß eine erste Wärmeenergiequelle, die in einem oberen Bereich einer Lötkammer des Reflow-Lötofen angeordnet ist, eine Wärmeenergie erzeugt, die auf die erste Seite der Leiterplatte einwirkt und die zu einer Temperatur an den dort bestückten Bauteilen führt (96), die kleiner ist als eine kritische Temperatur des thermisch kritischen SMD-Bauteils;
• wobei eine zweite Wärmeenergiequelle, die in einem unteren Bereich der Lötkammer des Reflow-Lötofen angeordnet ist, eine Wärmeenergie erzeugt, die auf eine zweite untere Seite der Leiterplatte einwirkt und die durch die Leiterplatte hindurch zur ersten Seite der Leiterplatte übertragen wird und in der Lotpaste auf der ersten Seite der Leiterplatte ein Aufschmelzen bewirkt,
• nach der Lötung der SMD-Bauteile auf der ersten Seite der Leiterplatte wird bleifreie Lotpaste auf die zweite Seite der Leiterplatte aufgetragen (98) und thermisch unkritische SMD-Bauteile werden in die Lotpaste auf der zweiten Seite eingesetzt (100),
• die Leiterplatte wird mit ihrer zweiten, bestückte Seite nach oben im Reflow-Lötofen derart plaziert und transportiert, daß die erste Wärmeenergiequelle eine Wärmeenergie erzeugt, die auf die oben liegende zweite Seite der Leiterplatte einwirkt und zu einer Aufschmelzung der bleifreien Lotpaste führt,
• wobei die Wärmeabgabe der im unteren Bereich der Lötkammer des Reflow-Lötofens angeordnete zweite Wärmeenergiequelle wenigstens soweit gedrosselt wird, daß auf der unten liegende erste Seite der Leiterplatte und an den darauf bereits gelöteten SMD-Bauteilen eine Temperatur erreicht wird, die kleiner ist als eine kritische Temperatur des thermisch kritischen SMD-Bauteils.

2. Verfahren zum Löten von SMD-Bauteilen auf einer Leiterplatte mit bleifreier Lotpaste in einem Reflow-Lötofen, **gekennzeichnet durch** folgende Verfahrensschritte:
• nach Auftragen der Lotpaste auf eine erste Seite der Leiterplatte werden thermisch unkritische SMD-Bauteile und wenigstens ein thermisch kritisches SMD-Bauteil in die Lotpaste eingesetzt;
• die bestückte Leiterplatte wird mit ihrer ersten Seite nach oben in einem Reflow-Lötofen derart plaziert und transportiert, daß eine erste Wärmeenergiequelle, die in einem oberen Bereich einer Lötkammer des Reflow-Lötofen angeordnet ist, eine Wärmeenergie erzeugt, die auf die erste Seite der Leiterplatte einwirkt und die zu einer Temperatur an den dort bestückten Bauteilen führt, die kleiner ist als eine kritische Temperatur des thermisch kritischen SMD-Bauteils;
• wobei eine zweite Wärmeenergiequelle, die in einem unteren Bereich der Lötkammer des Reflow-Lötofen angeordnet ist, eine Wärmeenergie erzeugt, die auf eine zweite untere Seite der Leiterplatte einwirkt und die durch die Leiterplatte hindurch zur ersten Seite der Leiterplatte übertragen wird und in der Lotpaste auf der ersten Seite der Leiterplatte ein Aufschmelzen bewirkt,
• nach der Lötung der SMD-Bauteile auf der ersten Seite der Leiterplatte wird bleifreie Lotpaste auf die zweite Seite der Leiterplatte aufgetragen und thermisch unkritische SMD-Bauteile werden in die Lotpaste auf der zweiten Seite eingesetzt;
• die Leiterplatte wird mit ihrer zweiten, bestückte Seite nach oben im Reflow-Lötofen derart plaziert und transportiert, daß die erste Wärmeenergiequelle eine Wärmeenergie erzeugt, die auf die oben liegende zweite Seite der Leiterplatte einwirkt und zu einer Aufschmelzung der bleifreien Lotpaste führt,
• wobei im unteren Bereich der Lötkammer des Reflow-Lötofens eine Kühlvorrichtung angeordnet ist, die zum Kühlen der unten liegenden ersten Seite der Leiterplatte und der darauf bereits gelöteten SMD-Bauteile dient, so daß an den darauf bereits gelöteten SMD-Bauteilen eine Temperatur erreicht wird, die kleiner ist als eine kritische Temperatur des thermisch kritischen SMD-Bauteils.

3. Verfahren nach einem der Ansprüche 1 oder 2, **dadurch gekennzeichnet, daß** für den Fall einer Bestückung und Lötung der ersten Seite der Leiterplatte mit wenigstens einem bedrahteten Bauteil,
• die Leiterplatte nach dem Auftragen der Lotpaste auf die zweite Seite gewendet wird;
• Anschlußdrähte bzw. -Pins des bedrahteten Bauteils von der ersten Seite der Leiterplatte her in dafür vorgesehene Anschlußbohrungen gesteckt werden;
• die Leiterplatte dann gewendet wird; und
• die SMD-Bauteile auf der zweiten Seite in die Lotpaste eingesetzt werden

4. Verfahren nach einem der Ansprüche 1 bis 3, **dadurch gekennzeichnet, daß** die zweite Wärmeenergiequelle im Reflowofen wenigstens einen Infrarot-Strahler umfaßt.

5. Verfahren nach einem der Ansprüche 1 bis 4, **dadurch gekennzeichnet,**
**daß** durch teilweise Abdeckung der zweiten Seite der Leiterplatte eine punktuelle Einwirkung der Wärmeenergie der zweiten Wärmeenergiequelle auf die zweite Seite der Leiterplatte erreicht wird.

6. Verfahren nach Anspruch 5, **dadurch gekennzeichnet, daß** die teilweise Abdeckung der zweiten Seite der Leiterplatte mit einer Maske erreicht wird.

7. Reflow-Lötofen (30) zum Löten von SMD-Bauteilen und wenigstens einem auf einer ersten Seite einer Leiterplatte (10) in bleifreie Lotpaste eingesetztem thermisch kritischen SMD-Bauteil, welcher Reflow-Lötofen eine in einem oberen Bereich einer Lötkammer des Reflow-Lötofen angeordnete erste Wärmeenergiequelle aufweist und eine in einem unteren Bereich der Lötkammer des Reflow-Lötofen angeordnete zweite Wärmeenergiequelle,
wobei die von den Wärmeenergiequellen abgegebenen Wärmeenergien unabhängig voneinander so einstellbar sind, daß
• zum Löten von des thermisch kritischen SMD-Bauteils (22) auf der ersten Seite der Leiterplatte die von der zweiten Wärmeenergiequelle erzeugte Wärmeenergie auf eine zweite Seite der Leiterplatte so einwirkt, daß die Wärmeenergie durch die Leiterplatte hindurch übertragen und die Lotpaste auf der ersten Seite der Leiterplatte schmilzt;
• wobei nach einem Wenden der Leiterplatte zum Löten von SMD-Bauteilen, die auf einer zweiten Seite der Leiterplatte in bleifreie Lotpaste eingesetzt sind, eine im unteren Bereich der Lötkammer des Reflow-Lötofens angeordnete Kühlvorrichtung die ersten Seite der Leiterplatte und der darauf bereits gelöteten SMD-Bauteile so kühlt, daß an den darauf bereits gelöteten SMD-Bauteilen eine Temperatur erreicht wird, die kleiner ist als eine kritische Temperatur des thermisch kritischen SMD-Bauteils;
• wobei die zweite Wärmeenergiequelle wenigstens einen Infrarot-Strahler (58b, 80) umfaßt; und
• die Kühlvorrichtung (72,82) und der Infrarotstrahler eine gemeinsame Baugruppe (70) bilden.

8. Reflow-Lötofen nach Anspruch 7, **dadurch gekennzeichnet, daß** die gemeinsame Baugruppe aus Kühlvorrichtung und Infrarotstrahler wenigstens einen Anschluß für ein Kühlmittel aufweist.

9. Reflow-Lötofen nach einem der Ansprüche 7 oder 8, **dadurch gekennzeichnet, daß** die gemeinsame Baugruppe aus Kühlvorrichtung und Infrarotstrahler eine der Leiterplatte zugewandte gerippte Oberfläche aufweist auf oder in der Infrarotstrahler angeordnet sind.

## Claims

1. Method for soldering surface mounted components (SMC) onto a printed circuit board (PCB) with unleaded soldering paste in a reflow soldering furnace, **characterized by** the following process steps.
- after applying the soldering paste (92) to a first side of the printed circuit board, thermally uncritical SMCs and at least one thermally critical SMC are inserted into the soldering paste (94)
- with its first side facing upwards, the assembled printed circuit board is placed and transported in a reflow soldering furnace in such a way that a first thermal energy source, which is arranged in an upper section of a soldering chamber of the reflow soldering furnace, generates thermal energy, which acts on the first side of the printed circuit board and which results in a temperature at the assembled components (96) which is lower than a critical temperature of the thermally critical SMC;
- where a second thermal energy source, which is arranged in a lower section of the soldering chamber of the reflow soldering furnace, generates thermal energy, which acts on a second lower side of the printed circuit board and which is transferred through the PCB to the first side of the PCB and causes fusion in the soldering paste on the first side of the PCB;
- after soldering the SMCs on the first side of the PCB, unleaded soldering paste is applied to the second side of the PCB (98) and thermally uncritical SMCs are inserted into the soldering paste on the second side (100);
- with its second assembled side facing upwards, the PCB is placed and transported in the reflow soldering furnace in such a way that the first thermal energy source generates thermal energy which acts on the upper second side of the PCB and causes fusion of the unleaded soldering paste;
- where the heat given off by the second thermal energy source, which is arranged in the lower section of the soldering chamber of the reflow soldering furnace, is at least throttled in such a way that a temperature is reached on the first side of the PCB at the bottom, and on the SMCs already soldered to the PCB, said temperature being lower than a critical temperature of the thermally critical SMC.

2. Method for soldering SMCs to a PCB with unleaded soldering paste in a reflow soldering furnace, **characterized by** the following process steps:
- after applying the soldering paste to a first side of the printed circuit board, thermally uncritical SMCs and at least one thermally critical SMC are inserted into the soldering paste;
- with its first side facing upwards, the assembled printed circuit board is placed and transported in a reflow soldering furnace in such a way that a first thermal energy source, which is arranged in an upper section of a soldering chamber of the reflow soldering furnace, generates thermal energy, which acts on the first side of the printed circuit board and which results in a temperature at the assembled components which is lower than a critical temperature of the thermally critical SMC;
- where a second thermal energy source, which is arranged in a lower section of the soldering chamber of the reflow soldering furnace generates thermal energy, which acts on a second lower side of the printed circuit board and which is transferred through the PCB to the first side of the PCB and causes fusion in the soldering paste on the first side of the PCB;
- after soldering the SMCs on the first side of the PCB, unleaded soldering paste is applied to the second side of the PCB and thermally uncritical SMCs are inserted into the soldering paste on the second side;
- with its second assembled side facing upwards, the PCB is placed and transported in the reflow soldering furnace in such a way that the first thermal energy source generates a thermal energy which acts on the upper second side of the PCB and causes fusion of the unleaded soldering paste;
- where a cooling unit is arranged in the lower section of the soldering chamber of the reflow soldering furnace, said cooling unit serving to cool the lower first side of the PCB and the SMCs already soldered to the PCB such that a temperature is reached at the SMCs already soldered to the PCB, said temperature being lower than a critical temperature of the thermally critical SMC.

3. Method as per one of the Claims 1 or 2, **characterized in that**, when assembling and soldering the first side of the PCB with at least one wired component,
- the PCB is turned after applying the soldering paste to the second side;
- connection wires or pins of the wired component are inserted from the first side of the PCB into specially provided connection bores;
- the PCB is then turned;
- and the SMCs on the second side are inserted into the soldering paste

4. Method as per one of the Claims 1 to 3, **characterized in that** the second thermal energy source in the reflow furnace is at least an infrared heater.

5. Method as per one of the Claims 1 to 4, **characterized in that** partially covering the second side of the PCB causes the thermal energy of the second thermal energy source to act on the second side of the PCB.

6. Method as per Claim 5, **characterized in that** a mask is used to partially cover the second side of the PCB.

7. Reflow soldering furnace (30) for soldering SMCs and at least one thermally critical SMC inserted in unleaded soldering paste on a first side of a printed circuit board (10), said reflow soldering furnace having a first thermal energy source arranged in an upper section of a soldering chamber of the reflow soldering furnace, and a second thermal energy source arranged in a lower section of the soldering chamber of the reflow soldering furnace, where the thermal energies given off by the thermal energy sources can be independently adjusted in such a way that
- to solder the thermally critical SMC (22) to the first side of the PCB, the thermal energy generated by the second thermal energy source acts on a second side of the PCB in such a way that the thermal energy is transferred through the PCB and the soldering paste on the first side of the PCB melts.
- where, once the PCB is turned to solder SMCs which are inserted in unleaded soldering paste on a second side of the PCB, a cooling unit arranged in the lower section of the soldering chamber of the reflow soldering furnace cools the first side of the PCB and the SMCs already soldered onto the PCB in such a way that, at the already soldered SMCs, a temperature is reached which is lower than a critical temperature of the thermally critical SMC;
- where the second thermal energy source is at least an infrared heater (58b, 80) and
- the cooling unit (72, 82) and the infrared heater form a common module (70).

8. Reflow soldering furnace as per Claim 7, **characterized in that** the common module consisting of the cooling unit and infrared heater has at least one connection for a cooling agent.

9. Reflow soldering furnace as per Claim 7 or 8, **characterized in that** the common assembly, consisting of the cooling unit and the infrared heater, has a corrugated surface which faces the PCB, and on which surface or in which surface infrared heaters are arranged.

## Revendications

1. Procédé destiné au soudage de composants CMS sur un circuit imprimé avec une pâte à souder sans plomb dans un four de soudage par refusion, **caractérisé par** les étapes de processus suivantes :
• après l'application de la pâte à souder (92) sur une première face du circuit imprimé, des composants CMS thermiquement non critiques et au moins un composant CMS thermiquement critique sont montés dans la pâte à souder (94),
• le circuit imprimé équipé est placé avec sa première face orientée vers le haut dans un four de soudage par refusion et transporté de telle manière qu'une première source d'énergie thermique, laquelle est disposée dans une zone supérieure de la chambre de soudage du four de soudage par refusion, génère une énergie thermique, qui agit sur la première face du circuit imprimé et qui conduit, au niveau des composants, qui y sont implantés (96), à une température inférieure à la température critique du composant CMS thermiquement critique,
• une deuxième source d'énergie thermique, laquelle est disposée dans une zone inférieure de la chambre de soudage du four de soudage par refusion, générant une énergie thermique, qui agit sur une deuxième face inférieure du circuit imprimé et qui est transmise à travers le circuit imprimé vers la première face du circuit imprimé et provoque une fusion de la pâte à souder sur la première face du circuit imprimé,
• après le soudage des composants CMS sur la première face du circuit imprimé, de la pâte à souder est appliquée sur la deuxième face du circuit imprimé (98) et des composants CMS thermiquement non critiques sont montés dans la pâte à souder sur la deuxième face (100),
• le circuit imprimé est placé avec sa deuxième face équipée, orientée vers le haut, dans un four de soudage par refusion et transporté de telle manière que la première source d'énergie thermique génère une énergie thermique, qui agit sur la deuxième face du circuit imprimé située en haut et conduit à une fusion de la pâte à souder sans plomb,
• le dégagement de chaleur de la deuxième source d'énergie thermique disposée dans la zone inférieure de la chambre de soudage du four de soudage par refusion étant restreint au minimum de manière à ce que soit atteinte sur la première face du circuit imprimé, située en bas, et sur les composants CMS qui y sont déjà soudés, une température inférieure à une température critique du composant CMS thermiquement critique.

2. Procédé destiné au soudage de composants CMS sur un circuit imprimé avec une pâte à souder sans plomb dans un four de soudage par refusion, **caractérisé par** les étapes de processus suivantes :
• après l'application de la pâte à souder sur une première face du circuit imprimé, des composants CMS thermiquement non critiques et au moins un composant CMS thermiquement critique sont montés dans la pâte à souder,
• le circuit imprimé équipé est placé avec sa première face orientée vers le haut dans un four de soudage par refusion et transporté de telle manière qu'une première source d'énergie thermique, laquelle est disposée dans une zone supérieure de la chambre de soudage du four de soudage par refusion, génère une énergie thermique, qui agit sur la première face du circuit imprimé et qui conduit, au niveau des composants, qui y sont implantés, à une température inférieure à la température critique du composant CMS thermiquement critique,
• une deuxième source d'énergie thermique, laquelle est disposée dans une zone inférieure de la chambre de soudage du four de soudage par refusion, générant une énergie thermique, qui agit sur une deuxième face inférieure du circuit imprimé et qui est transmise à travers le circuit imprimé vers la première face du circuit imprimé et provoque une fusion de la pâte à souder sur la première face du circuit imprimé,
• après le soudage des composants CMS sur la première face du circuit imprimé, de la pâte à souder est appliquée sur la deuxième face du circuit imprimé et des composants CMS thermiquement non critiques sont montés dans la pâte à souder sur la deuxième face,
• le circuit imprimé est placé avec sa deuxième face équipée, orientée vers le haut, dans un four de soudage par refusion et transporté de telle manière que la première source d'énergie thermique génère une énergie thermique, qui agit sur la deuxième face du circuit imprimé située en haut et conduit à une fusion de la pâte à souder sans plomb,
• un dispositif de refroidissement étant prévu dans la zone inférieure de la chambre de soudage du four de soudage de refusion, lequel dispositif sert au refroidissement de la première face, située en bas, du circuit imprimé et des composants CMS, qui y sont déjà soudés, si bien que soit atteinte sur les composants CMS, qui y sont déjà soudés, une température inférieure à la température critique du composant CMS thermiquement critique.

3. Procédé selon l'une des revendications 1 ou 2, **caractérisé en ce que,** pour le cas d'un équipement et d'un soudage de la première face du circuit imprimé avec au moins un composant câblé,
• le circuit imprimé est retourné sur la deuxième face après l'application de la pâte à souder;
• les fils ou broches de raccordement du composant câblé sont introduits depuis la première face du circuit imprimé dans des trous de raccordement prévus à cette fin ;
• le circuit imprimé est ensuite retourné ; et
• les composants CMS sont montés dans la pâte à souder sur la deuxième face.

4. Procédé selon l'une des revendications 1 à 3, **caractérisé en ce que** la deuxième source d'énergie thermique comprend dans le four de soudage par refusion au moins un radiateur à infrarouge.

5. Procédé selon l'une des revendications 1 à 4, **caractérisé en ce qu'**est obtenu par un recouvrement partiel de la deuxième face du circuit imprimé un effet ponctuel de l'énergie thermique de la deuxième source d'énergie thermique sur la deuxième face du circuit imprimé.

6. Procédé selon la revendication 5, **caractérisé en ce que** le recouvrement partiel de la deuxième face du circuit imprimé est obtenu à l'aide d'un masque.

7. Four de soudage par refusion (30) destiné au soudage de composants CMS et d'au moins un composant CMS thermiquement critique, monté dans une pâte à souder sans plomb sur une première face d'un premier circuit imprimé (10), lequel four de soudage par refusion comporte une première source d'énergie thermique disposée dans une zone supérieure d'une chambre de soudage du four de soudage par refusion et une deuxième source d'énergie thermique disposée dans une zone inférieure de la chambre de soudage du four de soudage par refusion, les énergies thermiques produites par les sources d'énergie thermique étant réglables indépendamment l'une de l'autre, de telle manière que
• l'énergie thermique générée par la deuxième source d'énergie pour le soudage du composant CMS thermiquement critique (22) sur la première face du circuit imprimé agit sur une deuxième face du circuit imprimé de telle manière que l'énergie thermique soit transmise à travers le circuit imprimé et la pâte à souder sur la première face du circuit imprimé fonde ;
• four pour lequel, après un retournement du circuit imprimé pour le soudage de composants CMS, qui sont montés dans une pâte à souder sans plomb sur une deuxième face du circuit imprimé, un dispositif de refroidissement disposé dans la zone inférieure de la chambre de soudage du four de soudage par refusion refroidit la première face du circuit imprimé et les composants CMS, qui y sont déjà soudés, de telle manière que soit atteinte sur les composants CMS, qui y sont déjà soudés, une température inférieure à une température critique du composant CMS thermiquement critique ;
• la deuxième source d'énergie thermique comprenant au moins un radiateur à infrarouge (586, 80) ; et
• le dispositif de refroidissement (72, 82) et le radiateur à infrarouge constituant un sous-groupe commun (70).

8. Four de soudage par refusion selon la revendication 7, **caractérisé en ce que** le sous-groupe commun constitué du dispositif de refroidissement et du radiateur à infrarouge comporte au moins un raccord pour un liquide de refroidissement.

9. Four de soudage par refusion selon l'une des revendications 7 ou 8, **caractérisé en ce que** le sous-groupe commun constitué du dispositif de refroidissement et du radiateur à infrarouge présente une surface nervurée orientée vers le circuit imprimé, dans laquelle ou sur laquelle sont disposés des radiateurs à infrarouge.
